# EUROPEAN PATENT APPLICATION

(11) **EP 4 848 593 A1**
(43) Date of publication of application: **02.12.2026**
(21) Application number: 26164794.5
(22) Date of filing: 13.03.2026
(51) Int. Cl.: H03M 7/30, G06F 17/16, G06N 3/063

(54) **COMPRESSED REPRESENTATION OF DATA FOR EFFICIENT MEMORY STORAGE**

(30) Priority: 30.05.2025 US 202519223149
(71) Applicant: Google LLC, Mountain View, CA 94043 (US)
(72) Inventor: Motamarri, Venkateshwar, 560016 Bangalore (IN); Ganapathineedi, Manoj Kumar, 560016 Bangalore (IN)
(74) Representative: Marks & Clerk GST

(57) **Abstract**

Methods and systems for generating compressed representations of data. In an aspect, operations include generating, based on input data of *M x N* elements, wherein the input data includes *K* non-zero values in the elements, and the number of unique values in the *K* non-zero values is *J,* a unique values data that includes *J* first elements, wherein each first element includes a respective unique value for each unique value in the input data, and each unique value is included in the unique values data only once; generating, based on the unique values data and the input data, a value mapping vector that includes K second elements and *J* second element values, each second element value corresponding to a value in the unique values; and storing, in a storage memory, the unique values data, the value mapping vector, a column index vector, and a row index vector.

## Description

### BACKGROUND

This specification generally relates to efficient memory storage techniques.

Many systems and applications use large data matrices when processing data, and many of the element values in the matrices are duplicative. For example, large language models (LLMs) use dense weight matrices of quantized weights. Processes such as compressed sparse row (CSR) or compresses sparse column (CSC) reduce the amount of memory required to store representations of such matrices; however, both CSR and CSC store duplicate values of unique terms. For example, assume an *M x N* matrix of *M* rows and *N* columns has *K* non-zero values, and the number of unique values in the *K* non-zero values is *J.* In CSR and CSC, a data vector having *K* elements listing the unique values is required. For example, for the following matrix of *K=* 8 non-zero values with *J =* 2 unique values: $\begin{matrix}\left[7 0 7 0\right] \\ \left[0 3 0 7\right] \\ \left[7 0 3 0\right] \\ \left[0 7 0 3\right]\end{matrix}$

The following data vector is required: [7 7 3 7 7 3 7 3].

While the use of the data vector in addition to a column vector and row vector results is a compressed representation of the *M x N* matrix, the redundant list of unique values incurs a storage overhead inefficiency. This inefficiency scales with the size of the *M x N* matrix.

### SUMMARY

This specification describes a technique for achieving weight memory-compression in ML inference accelerators. The technique achieves the memory-compression by deduplicating sparse matrix representations (CSR, CSC) to reduce a memory footprint for redundant (repeated) values.

In an implementation, a method performed using a computing device to reduce storage in a data representation comprises: receiving, at the computing device, input data defining an *M x N* matrix of *M* rows and *N* columns, and having *M x N* elements, wherein the input data includes *K* non-zero values in the *M x N* elements, and the number of unique values in the *K* non-zero values is J; generating, based on the input data, a unique values data that includes *J* first elements, wherein each first element includes a respective unique value for each unique value in the input data, and each unique value is included in the unique values data only once; generating, based on the unique values data and the input data, a value mapping vector that includes *K* second elements and *J* second element values, each second element value corresponding to a value in the unique values; generating a column index vector and a row index vector that respectively indicate, at each element, one of i) column indices in the *M x N* matrix for non-zero values and indices corresponding to the value mapping vector that indicate a start of a row's non-zero value, or ii) row indices in the *M x N* matrix for non-zero values and indices corresponding to the value mapping vector that indicate a start of a column's non-zero value; and storing, in a computer device memory, the unique values data, the value mapping vector, the column index vector, and the row index vector as a reduced-memory representation of the input data. Other embodiments of this aspect include corresponding methods, apparatus, and computer programs, configured to perform the actions of the methods, encoded on computer storage devices.

In an implementation in combination with the above, generating the value mapping vector comprises allocating log2(*J*) bits for each second element value.

In another implementation in combination with any of the above, the unique values data is a unique values vector, and each first element is a respective unique value; and each second element value in the value mapping vector is a respective index of the unique values vector.

In another implementation in combination with any of the above, generating a column index vector and a row index vector comprises: generating a column index vector that includes *K* third elements that respectively correspond to the *K* second elements of the value mapping vector, and each third element value specifies a column value of a column in which a unique value in the unique value vector at the corresponding index value of the value mapping vector is located in the *M x N* matrix; and generating, based on the input data, a row index vector of *M +* 1 fourth elements, wherein each of the first *M* fourth elements in the row index vector is an index value of a second element in the value mapping vector that corresponds to a value in the unique value vector that is a first non-zero value in a corresponding row of the *M x N* matrix.

In another implementation in combination with any of the above, each unique value of the input data is a quantized weight or activation of an element in a neural network layer.

In another implementation in combination with any of the above, reconstruction of the input data from the reduced-memory representation of the input data comprises generating, from the unique values vector and the value mapping vector, a data vector, wherein the data vector includes *K* fifth elements that are the *K* non-zero values in the *M x N* elements.

In another implementation, the reconstruction of the input data from the reduce-memory representation of the input data further comprising reconstructing the input data based on the data vector, column index vector, and row index vector input using a Compressed Sparse Row (CSR) reconstruction algorithm when the column index vector stores column indices in the *M x N* matrix for non-zero values and the row index vector stores indices corresponding to the value mapping vector that indicate a start of a row's non-zero value.

In another implementation, reconstruction of the input data from the reduce-memory representation of the input data further comprising reconstructing the input data based on the data vector, column index vector, and row index vector input using a Compressed Sparse Column (CSC) reconstruction algorithm when the row index vector stores row indices in the *M x N* matrix for non-zero values and column index vector stores indices corresponding to the value mapping vector that indicate a start of a column's non-zero value.

In another implementation, the unique values data is a unique value mapping of each respective unique value to a respective second element value in the value mapping vector.

In another implementation in combination with the above, computer generating a column index vector and a row index vector comprises: generating a column index vector that includes *K* third elements that respectively correspond to the *K* second elements of the value mapping vector, and each third element value specifies a column value of a column in which a unique value in the unique value mapping mapped to the corresponding second elements of the value mapping vector is located in the *M x N* matrix; and generating, based on the input data, a row index vector of *M +* 1 fourth elements, wherein each of the first *M* fourth elements in the row index vector is an index value of a second element in the value mapping vector mapped to a value in the unique value vector that is a first non-zero value in a corresponding row of the *M x N* matrix.

The subject matter described in this specification can be implemented in particular embodiments to realize one or more of the following advantages. A streamlined weight value lookup operation is implemented using the value mapping vector and indexing logic is applied to reconstruct a sparse row format of the stored unique weight values. For example, to reconstruct the unique weight values, a simple lookup is performed using mapping indices that map an index value to an entry in the memory structure that stores a particular unique weight value. The weight memory-compression technique provides a hardware efficient approach for reducing a memory footprint of recurring weight values for any type of application in which an *M x N* matrix is used for manipulating data, solving equations, and modeling various phenomena, e.g., power system flows, market analysis, quantized neural network ML models, to name a few.

Memory storage is reduced in proportion to the number of redundant values in the *M x N* matrix. In particular, the use of quantized values in many applications can result in a large number of redundant values in input data. For many applications, these savings can be on the order of 20% or more, which is significant. The reduced memory footprint frees up computing resources, which is a technical improvement in the field of data storage.

In some implementations, a streamlined weight value lookup operation is implemented using the value mapping vector and indexing logic is applied to reconstruct a CSR or CSC format of the stored unique weight values. For example, to reconstruct the unique weight values, a simple lookup is performed using mapping indices that map an index value to an entry in the memory structure that stores a particular unique value. This technique provides a hardware efficient approach for reducing a memory footprint of recurring weight values in memory.

The details of one or more implementations of the subject matter described in this specification are set forth in the accompanying drawings and the description below. Other potential features, aspects, and advantages of the subject matter will become apparent from the description, the drawings, and the claims.

### BRIEF DESCRIPTION OF THE DRAWINGS

Fig. 1 is a system flow diagram of a system for reducing storage in a data representation.
Fig. 2 is a flow diagram of an example process for generating values data and a values mapping vector.
Fig. 3 is a flow diagram of an example process of reconstructing input data from a data representation that includes values data and a values mapping vector.

Like reference numbers and designations in the various drawings indicate like elements.

### DETAILED DESCRIPTION

To reduce the storage overhead, the systems and methods described herein utilize unique values data and a value mapping vector (VMV). The unique values data includes *J* first elements, each of which includes a respective unique value for each unique value in the input data, and each unique value is included in the unique values data only once. For example, for the following matrix of *K=* 8 non-zero values with *J =* 2 unique values: $\begin{matrix}\left[7 0 7 0\right] \\ \left[0 3 0 7\right] \\ \left[7 0 3 0\right] \\ \left[0 7 0 3\right]\end{matrix}$

The unique values data is: [3, 7].

The value mapping vector includes *K* second elements and *J* second element values, each second element value corresponding to a value in the unique values. For example, for the matrix above, the value mapping vector is: [1 1 0 1 1 0 1 0]

Additionally, because the value mapping vector only includes *J* = *2* second element values (0 or 1), the memory allocation for each element can be reduced to the ceiling of log₂(*J)*. In this example, the memory allocation is thus 1 bit, and the storage allocation for the entire array is 8 bits (8 elements * 1 bit).

For this example, assume that for the prior art data vector of [7 7 3 7 7 3 7 3], the allocation required for each value is 8 bits. The memory savings is thus: 64 bits - 8 * 2 bits (for the unique value vector) - 8 bits (for the value mapping vector) = 40 bits.

While the remaining CSR or CSC data (column index vector and row index vector) are the same, the resulting memory savings are still significant. For example, savings in larger CSR/CSC data sets (on the order of 500 MB) can be in excess of 20% using the systems and methods described herein.

These features and additional features are described in the claims that follow.

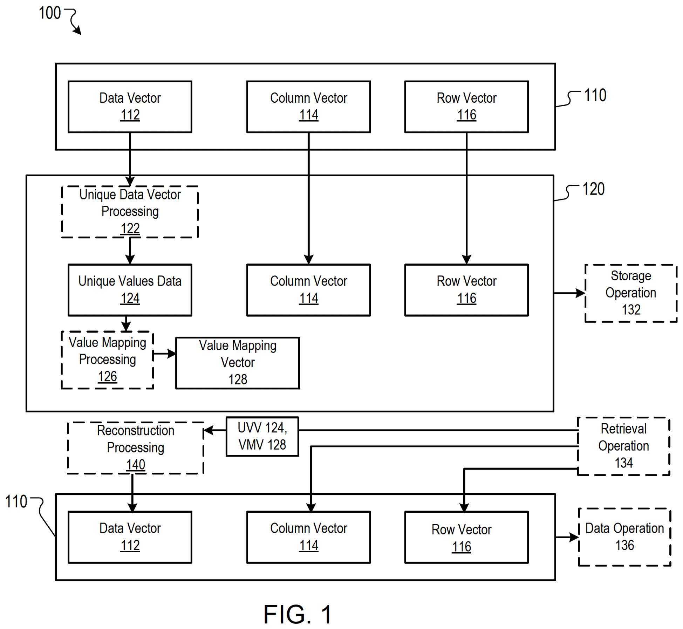

Fig. 1 is a system flow diagram of a system 100 for reducing storage in a data representation. The system can be any system that includes one or more processors and a non-transitory computer storage medium storing instructions that, when executed by the one or more processors, cause the system 100 to perform the operations describe below.

In operation, the system 100 receives input data 110 defining an *M x N* matrix of *M* rows and *N* columns and having *M x N* elements. The input data 110 so represented includes *K* non-zero values in the *M x N* elements, and the number of unique values in the *K* non-zero values is *J.* For example, in some implementations, the system may receive the entire matrix in raw, uncompressed form, e.g., the matrix: $\begin{matrix}\left[7 0 7 0\right] \\ \left[0 3 0 7\right] \\ \left[7 0 3 0\right] \\ \left[0 7 0 3\right]\end{matrix}$

For this matrix, the value of *K* is 8, and the value of *J* is 2.

Alternatively, the input data may be a compressed representation of the matrix, such as CSR or CSC data. For example, the input data 110 may be a CSR representation that includes a data vector 112, column vector 114, and row vector 116. For the example matrix above, the vectors 112, 114 and 116 would be:
Data Vector: [7, 7, 3, 7, 7, 3, 7, 3]
Column Vector: [0, 2, 1, 3, 0, 2, 1, 3]
Row Vector: [0, 2, 4, 6, 8]

In yet another alternative, CSC data could be received. However, for brevity, the following description will focus on the CSR data example. It is to be understood, however, the same principles apply to CSC data.

A processing block 120 processes the input data 110 for efficient storage. Because the column vector 114 and the row vector 116 are already in a compact form for storage, they can be copied directly to storage. However, the data vector 112, which typically includes multiple duplicate values, is first processed by a unique data vector processing 122 operation to generate a unique values data 124. For example, the data vector 112 of [7, 7, 3, 7, 7, 3, 7, 3] is processed to identify two unique values: 3 and 7. This can be done by any appropriate process that identifies and lists duplicate values. For example, the data vector 112 can be processed and a dictionary created for each unique value encountered. The dictionary will pair each unique value with a mapping value that ranges from 0 *- J-*1*.*

The unique values data of *J* = 2 elements is then generated, e.g., [3, 7]. Note that each unique value - 3 and 7 - is included in the unique values data only once. While the unique value vector is shown as an array ascending elements, the order of the unique values is not important, and in various implementations the unique values can be included in the unique values data in any order.

A value mapping process 126 then takes the data vector 112 and the unique values data 124 to generate a value mapping vector 128. The value mapping vector includes *K* second elements and *J* second element values. Each second element value corresponds to a value in the unique values. For example, for the data vector of [7, 7, 3, 7, 7, 3, 7, 3] and the unique values data being a vector of [3, 7], the processing block 120 generates the value mapping vector by assigning to each element in the value mapping vector an index into the unique values vector of the element with the corresponding value in the data vector 112. Thus, for the data vector 112 of [7, 7, 3, 7, 7, 3, 7, 3] and the unique values vector data 124 of [3, 7], the value mapping vector VMV is [1, 1, 0, 1, 1, 0, 1, 0]. This is because in the unique values vector (UVV) of [3, 7], UVV[0] is 3, and UVV[1] is 7. Note that if the UVV were [7, 3], the VMM would be [0, 0, 1, 0, 0, 1, 0 1]. Similarly, the mapping data can be used to populate the value mapping vector at each element by populating the value mapping vector with the corresponding value ranging from 0 to *J-1* based on the corresponding matching element in the data vector.

The unique values data 124, the value mapping vector 128, the column vector 114 and the row vector 116 are then stored in a computer memory device by a storage operation 132, e.g., a write operation. Because the value mapping vector has only *J* values, the processing block 120 can, in some implementations, allocate for each element in the value mapping vector 128 a number of bits equal to the ceiling value of log₂(*J*). For example, for *J* = 2, only 1 bit is required for storage of each element in the value mapping vector. Likewise, if *J* were a higher value, say 12, then four bits would be required for each element in the value mapping vector, as the ceiling value of log₂(12) is 4, i.e., ceil(log₂(12)) = ceil(3.585...) = 4.

When the input data are CSR data, then the column index vector and the row index vector respectively indicate, at each element, column indices in the *M x N* matrix for non-zero values and indices corresponding to the value mapping vector that indicate a start of a row's non-zero value. Conversely, when the input data are CSR data, then the column index vector and the row index vector respectively indicate row indices in the *M x N* matrix for non-zero values and indices corresponding to the value mapping vector that indicate a start of a column's non-zero value.

When the reduced storage data representation are needed for later processing, a retrieval operation 134, e.g., a read operation, reads the stored data and provides the stored column vector 114 and row vector 116 as output. However, a reconstruction of the data vector is required, and thus the read operation 134 provides the UVV 124 and the VMV 128 to a reconstruction process 128.

The reconstruction process 128 may vary on the type of data stored as the UVV 124. For example, if the UVV 124 is a vector of single elements, e.g., [3, 7] as shown above, then the process 128 generates, from the unique values vector and the value mapping vector, the data vector 112 with *K* elements that are each determined by using a corresponding value in the value mapping vector 128 as an index into the unique value vector, e.g., for a value mapping vector of *K* elements indexed at 0 ... *K - 1*, the data value vectors is generated by:$DV = \left[UVV\left[VMV\left[0\right]\right], UVV\left[VMV\left[1\right]\right], …UVV\left[VMV\left[K-1\right]\right]\right]$$DV = \left[UVV\left[1\right], UVV\left[1\right], UVV\left[0\right]…, UVV\left[0\right]\right]$$DV = \left[7, 7, 3, 7, 7, 3, 7, 3\right]$

In another implementation, the unique values data 128 can be a simple dictionary that includes a mapping of unique values to values in the value mapping vectors. For example, the unique value data can be a dictionary of [3:0, 7:1]. The data vector 112 is then reconstructed based on the mapping of unique values to values in the value mapping vector 128. Thus, for each *i^{th}* element in the data vector 112, the value is equal to the mapping of the *i^{th}* element value in the value mapping vector 128 to it corresponding value in the unique value data.

Once the data vector 112, column vector 114 and row vector 116 are output, they can be processed by a data operation 136. The data operation may depend on the processing objective, and may include restoring an original *M x N* matrix using convention CSR and CSC restoration techniques.

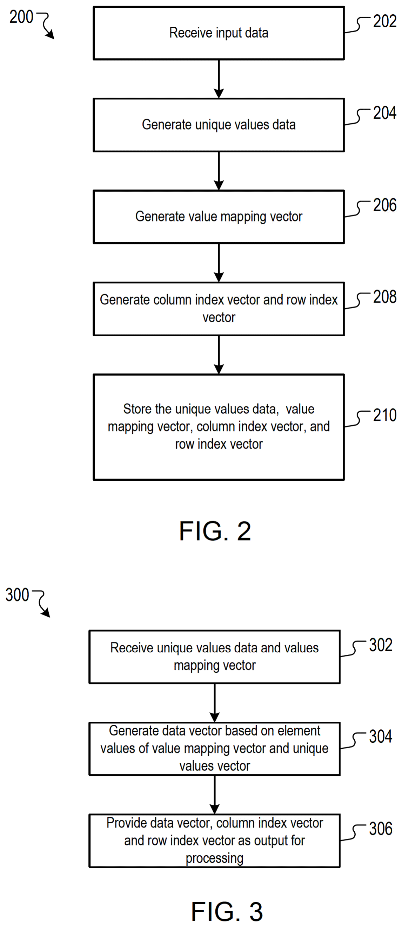

Fig. 2 is a flow diagram of an example process 200 for generating values data and a values mapping vector. The process 200 can be performed by one or more processors and a non-transitory computer storage medium storing instructions that, when executed by the one or more processors, cause the one or more processors to perform the operations describe below.

The process 200 receives input data (202). The input data defines an *M x N* matrix of *M* rows and *N* columns and having *M x N* elements. As described above, the input data so represented includes *K* non-zero values in the *M x N* elements, and the number of unique values in the *K* non-zero values is *J.* For example, in some implementations, the system may receive the entire matrix in raw, uncompressed form and generate CSR or CSC data. In other implementations, the input data may be a compressed representation of the matrix, such as CSR or CSC data. For example, the input data may be a CSR representation that includes a data vector, a column vector, and a row vector, as described above.

The process 200 generates unique values data (204). The process 200 generates the unique values data based on the input data. The unique values data includes *J* first elements. Each first element includes a respective unique value for each unique value in the input data, and each unique value is included in the unique values data only once.

For example, in implementations in which the input data includes a data vector, the data vector can be first processed by a unique data vector processing operation to generate a unique values data. For example, the data vector can be processed to identify unique values included in the data vector. This can be done by any appropriate process that identifies and lists duplicate values. For example, the data vector can be processed and a dictionary created for each unique value encountered. The dictionary will pair each unique value with a mapping value that ranges from 0 to *J -* 1.

The unique values included in the unique values data can be included in any suitable order. For example, the unique values order can be included in ascending order, in descending order, or in a random order.

The process 200 generates a value mapping vector (206). The process 200 generates the value mapping vector based on the unique values data and the input data. The value mapping vector includes *K* second elements and *J* second element values, each second element value corresponding to a value in the unique values data.

For example, as described above, the process 200 can generate the value mapping vector by assigning to each element in the value mapping vector an index into the vector representation of the unique values data of the element with the corresponding value in the data vector. Likewise, as described above, mapping data can be used to populate the value mapping vector at each element by populating the value mapping vector with the corresponding value ranging from 0 to *J* - 1 based on the corresponding matching element in the data vector.

The process 200 generates a column index vector and row index vector (208). In implementations in which the input data is a CSR representation, the column index vector indicates, at each element, column indices in the *M x N* matrix (e.g., defined by the input data) for non-zero values. In such implementations, the row index vector indicates, at each element, indices corresponding to the value mapping vector that indicate a start of a row's non-zero value.

In implementations in which the input data is a CSC representation, the column index vector indicates, at each element, row indices in the *M x N* matrix for non-zero values. In such implementations, the row index vector indicates, at each element, indices corresponding to the value mapping vector that indicate a start of a column's non-zero value.

The process 200 stores the unique values data, value mapping vector, column index vector, and row index vector (210). The process 200 stores the unique values data, value mapping vector, column index vector, and row index vector in a computer device memory as a reduced-memory representation of the data.

For example, as described above, the process 200 can store the unique values data, value mapping vector, column index vector, and row index vector using a storage operation, e.g., a write operation. The storage of these data and vectors can occupy less space in the computer device memory, e.g., as compared to some existing techniques. For example, as described above, because the value mapping vector has only *J* values, for each element of the value mapping vector, a number of bits can be allocated that is equal to the ceiling value of log₂(*J*). This number of bits can be smaller than a second number of bits allocated to each element of a data vector used to store the input data in some existing techniques, thereby reducing an amount of memory space used to maintain the data.

Fig. 3 is a flow diagram of an example process of reconstructing input data from a data representation that includes values data and a values mapping vector. The process 300 can be performed by one or more processors and a non-transitory computer storage medium storing instructions that, when executed by the one or more processors, cause the one or more processors to perform the operations describe below.

The process 300 receives unique values data and values mapping vector (302). In some implementations, the unique values data and the values mapping vector can have been generated based on the input data via the process 200 of FIG. 2.

For example, the input data can include *K* non-zero values in the *M x N* elements, and J unique values in the K non-zero values. The unique values data can include *J* elements, each element including a respective unique value for each unique value in the input data, and each unique value being included in the unique values data only once. The value mapping vector can include *K* elements and *J* element values, each element value corresponding to a value in the unique values data.

In some implementations, the input data can be a compressed representation of the matrix that includes a data vector, a column vector, and a row vector, as described above.

The process 300 generates a data vector based on element values of value mapping vector and unique values vector (304). The data vector includes *K* elements that are the K non-zero values in the M x N elements included in the input data.

As described above, in some implementations, the process 300 can determine each element of the data vector by using a corresponding value in the value mapping vector as an index into the vector representation of the unique values data, e.g.,
DV = [UVV[VMV[0]], UVV[VMV[1]], ...UVV[VMV[K-1]]].

In other implementations, the data vector can then be reconstructed based on the mapping of unique values to values in the values mapping vector. Thus, for each *i^{th}* element in the data vector, the value is equal to the mapping of the *i^{th}* element value in the value mapping vector to its corresponding value in the unique values data.

The process 300 provides the data vector, column index vector and row index vector as output for processing (306). For example, the data vector, column index vector, and row index vector can be processed by a data operation. The data operation may depend on the processing objective, and may include restoring an original *M x N* matrix using conventional CSR and CSC restoration techniques.

In some implementations, the respective steps of the processes described above are performed at a hardware integrated circuit as part of a larger compute operation to generate a machine-learning (ML) output, including an output for a neural network layer of a neural network that implements one or more ML models. For example, the output can be a portion of a computation for a ML task or inference workload to generate an image processing, speech processing, or image recognition output. As indicated above, a portion of the integrated circuit can include a special-purpose neural network processor or hardware ML accelerator configured to accelerate computations for generating different types of data processing outputs. The ML models include weight values that are quantized. The weight values can be represented in the *M x N* array, and thus can be represented by the compressed representations described above, and stored efficiently in computer memory.

In this specification, the term "configured" is used in relation to computing systems and environments, as well as computer program components. A computing system or environment is considered "configured" to perform specific operations or actions when it possesses the necessary software, firmware, hardware, or a combination thereof, enabling it to carry out those operations or actions during operation. For instance, configuring a system might involve installing a software library with specific algorithms, updating firmware with new instructions for handling data, or adding a hardware component for enhanced processing capabilities. Similarly, one or more computer programs are "configured" to perform particular operations or actions when they contain instructions that, upon execution by a computing device or hardware, cause the device to perform those intended operations or actions.

The embodiments and functional operations described in this specification can be implemented in various forms, including digital electronic circuitry, software, firmware, computer hardware (encompassing the disclosed structures and their structural equivalents), or any combination thereof. The subject matter can be realized as one or more computer programs, essentially modules of computer program instructions encoded on a tangible non-transitory storage medium for execution by or to control the operation of a computing device or hardware. The storage medium can be a storage device such as a hard drive or solid-state drive (SSD), a storage medium, a random or serial access memory device, or a combination of these. Additionally or alternatively, the program instructions can be encoded on a transmitted signal, such as a machine-generated electrical, optical, or electromagnetic signal, designed to carry information for transmission to a receiving device or system for execution by a computing device or hardware. Furthermore, implementations may leverage emerging technologies like quantum computing or neuromorphic computing for specific applications, and may be deployed in distributed or cloud-based environments where components reside on different machines or within a cloud infrastructure.

The term "computing device, "data processing apparatus," or "hardware" refers to the physical components involved in data processing and encompasses all types of devices and machines used for this purpose. Examples include processors or processing units, computers, multiple processors or computers working together, graphics processing units (GPUs), tensor processing units (TPUs), and specialized processing hardware such as field-programmable gate arrays (FPGAs) or application-specific integrated circuits (ASICs). In addition to hardware, a computing device or hardware may also include code that creates an execution environment for computer programs. This code can take the form of processor firmware, a protocol stack, a database management system, an operating system, or a combination of these elements. Embodiments may particularly benefit from utilizing the parallel processing capabilities of GPUs, in a General-Purpose computing on Graphics Processing Units (GPGPU) context, where code specifically designed for GPU execution, often called kernels or shaders, is employed. Similarly, TPUs excel at running optimized tensor operations crucial for many machine learning algorithms. By leveraging these accelerators and their specialized programming models, the system can achieve significant speedups and efficiency gains for tasks involving artificial intelligence and machine learning, particularly in areas such as computer vision, natural language processing, and robotics.

A computer program, also referred to as software, an application, a module, a script, code, or simply a program, can be written in any programming language, including compiled or interpreted languages, and declarative or procedural languages. It can be deployed in various forms, such as a standalone program, a module, a component, a subroutine, or any other unit suitable for use within a computing environment. A program may or may not correspond to a single file in a file system and can be stored in various ways. This includes being embedded within a file containing other programs or data (e.g., scripts within a markup language document), residing in a dedicated file, or distributed across multiple coordinated files (e.g., files storing modules, subprograms, or code segments). A computer program can be executed on a single computer or across multiple computers, whether located at a single site or distributed across multiple sites and interconnected through a data communication network. The specific implementation of the computer programs may involve a combination of traditional programming languages and specialized languages or libraries designed for GPGPU programming or TPU utilization, depending on the chosen hardware platform and desired performance characteristics.

In this specification, the term "engine" broadly refers to a software-based system, subsystem, or process designed to perform one or more specific functions. An engine is typically implemented as one or more software modules or components installed on one or more computers, which can be located at a single site or distributed across multiple locations. In some instances, one or more dedicated computers may be used for a particular engine, while in other cases, multiple engines may operate concurrently on the same one or more computers. Examples of engine functions within the context of AI and machine learning could include data pre-processing and cleaning, feature engineering and extraction, model training and optimization, inference and prediction generation, and post-processing of results. The specific design and implementation of engines will depend on the overall architecture and the distribution of computational tasks across various hardware components, including CPUs, GPUs, TPUs, and other specialized processors.

The processes and logic flows described in this specification can be executed by one or more programmable computers running one or more computer programs to perform functions by operating on input data and generating output. Additionally, graphics processing units (GPUs) and tensor processing units (TPUs) can be utilized to enable concurrent execution of aspects of these processes and logic flows, significantly accelerating performance. This approach offers significant advantages for computationally intensive tasks often found in AI and machine learning applications, such as matrix multiplications, convolutions, and other operations that exhibit a high degree of parallelism. By leveraging the parallel processing capabilities of GPUs and TPUs, significant speedups and efficiency gains compared to relying solely on CPUs can be achieved. Alternatively or in combination with programmable computers and specialized processors, these processes and logic flows can also be implemented using specialized processing hardware, such as field-programmable gate arrays (FPGAs) or application-specific integrated circuits (ASICs), for even greater performance or energy efficiency in specific use cases.

Computers capable of executing a computer program can be based on general-purpose microprocessors, special-purpose microprocessors, or a combination of both. They can also utilize any other type of central processing unit (CPU). Additionally, graphics processing units (GPUs), tensor processing units (TPUs), and other machine learning accelerators can be employed to enhance performance, particularly for tasks involving artificial intelligence and machine learning. These accelerators often work in conjunction with CPUs, handling specialized computations while the CPU manages overall system operations and other tasks. Typically, a CPU receives instructions and data from read-only memory (ROM), random access memory (RAM), or both. The elements of a computer include a CPU for executing instructions and one or more memory devices for storing instructions and data. The specific configuration of processing units and memory will depend on factors like the complexity of the AI model, the volume of data being processed, and the desired performance and latency requirements. Embodiments can be implemented on a wide range of computing platforms, from small, embedded devices with limited resources to large-scale data center systems with high-performance computing capabilities. The system may include storage devices like hard drives, SSDs, or flash memory for persistent data storage.

Computer-readable media suitable for storing computer program instructions and data encompass all forms of non-volatile memory, media, and memory devices. Examples include semiconductor memory devices such as read-only memory (ROM), solid-state drives (SSDs), and flash memory devices; hard disk drives (HDDs); optical media; and optical discs such as CDs, DVDs, and Blu-ray discs. The specific type of computer-readable media used will depend on factors such as the size of the data, access speed requirements, cost considerations, and the desired level of portability or permanence.

To facilitate user interaction, embodiments of the subject matter described in this specification can be implemented on a computing device equipped with a display device, such as a liquid crystal display (LCD) or an organic light-emitting diode (OLED) display, for presenting information to the user. Input can be provided by the user through various means, including a keyboard), touchscreens, voice commands, gesture recognition, or other input modalities depending on the specific device and application. Additional input methods can include acoustic, speech, or tactile input, while feedback to the user can take the form of visual, auditory, or tactile feedback. Furthermore, computers can interact with users by exchanging documents with a user's device or application. This can involve sending web content or data in response to requests or sending and receiving text messages or other forms of messages through mobile devices or messaging platforms. The selection of input and output modalities will depend on the specific application and the desired form of user interaction.

Machine learning models can be implemented and deployed using machine learning frameworks, such as TensorFlow or JAX. These frameworks offer comprehensive tools and libraries that facilitate the development, training, and deployment of machine learning models.

Embodiments of the subject matter described in this specification can be implemented within a computing system comprising one or more components, depending on the specific application and requirements. These may include a back-end component, such as a back-end server or cloud-based infrastructure; an optional middleware component, such as a middleware server or application programming interface (API), to facilitate communication and data exchange; and a front-end component, such as a client device with a user interface, a web browser, or an app, through which a user can interact with the implemented subject matter. For instance, the described functionality could be implemented solely on a client device (e.g., for on-device machine learning) or deployed as a combination of front-end and back-end components for more complex applications. These components, when present, can be interconnected using any form or medium of digital data communication, such as a communication network like a local area network (LAN) or a wide area network (WAN) including the Internet. The specific system architecture and choice of components will depend on factors such as the scale of the application, the need for real-time processing, data security requirements, and the desired user experience.

The computing system can include clients and servers that may be geographically separated and interact through a communication network. The specific type of network, such as a local area network (LAN), a wide area network (WAN), or the Internet, will depend on the reach and scale of the application. The client-server relationship is established through computer programs running on the respective computers and designed to communicate with each other using appropriate protocols. These protocols may include HTTP, TCP/IP, or other specialized protocols depending on the nature of the data being exchanged and the security requirements of the system. In certain embodiments, a server transmits data or instructions to a user's device, such as a computer, smartphone, or tablet, acting as a client. The client device can then process the received information, display results to the user, and potentially send data or feedback back to the server for further processing or storage. This allows for dynamic interactions between the user and the system, enabling a wide range of applications and functionalities.

In addition to the embodiments of the attached claims and the embodiments described above, the following numbered embodiments are also innovative:
Embodiment 1 is a computer-implemented method performed using computing device to reduce storage in a data representation, the method comprising: receiving, at computing device, input data defining an *M x N* matrix of *M* rows and *N* columns, and having *M x N* elements, wherein the input data includes *K* non-zero values in the *M x N* elements, and the number of unique values in the *K* non-zero values is J; generating, based on the input data, a unique values data that includes *J* first elements, wherein each first element includes a respective unique value for each unique value in the input data, and each unique value is included in the unique values data only once; generating, based on the unique values data and the input data, a value mapping vector that includes *K* second elements and *J* second element values, each second element value corresponding to a value in the unique values; and storing, in a computer device memory, the unique values data, the value mapping vector, a column index vector, and a row index vector as a reduced-memory representation of the input data, wherein the column index vector and the row index vector respectively indicate, at each element, one of i) column indices in the *M x N* matrix for non-zero values and indices corresponding to the value mapping vector that indicate a start of a row's non-zero value, or ii) row indices in the *M x N* matrix for non-zero values and indices corresponding to the value mapping vector that indicate a start of a column's non-zero value.
Embodiment 2 is the method of embodiment 1, wherein generating the value mapping vector comprises allocating log2(*J*) bits for each second element value.
Embodiment 3 is the method of embodiment 2, wherein: the unique values data is a unique values vector, and each first element is a respective unique value; and each second element value in the value mapping vector is a respective index of the unique values vector.
Embodiment 4 is the computer implemented method of embodiment 3, further comprising generating the column index vector and the row index vector, comprising: generating the column index vector that includes *K* third elements that respectively correspond to the *K* second elements of the value mapping vector, and each third element value specifies a column value of a column in which a unique value in the unique value vector at the corresponding index value of the value mapping vector is located in the *M x N* matrix; and generating, based on the input data, the row index vector of *M +* 1 fourth elements, wherein each of the first *M* fourth elements in the row index vector is an index value of a second element in the value mapping vector that corresponds to a value in the unique value vector that is a first non-zero value in a corresponding row of the *M x N* matrix.
Embodiment 5 is the method of embodiment 3 or 4, wherein each unique value of the input data is a quantized weight or activation of an element in a neural network layer.
Embodiment 6 is the method of any one of embodiments 2 to 5, further comprising reconstruction of the input data from the reduced-memory representation of the input data, comprising: generating, from the unique values vector and the value mapping vector, a data vector, wherein the data vector includes *K* fifth elements that are the *K* non-zero values in the *M x N* elements.
Embodiment 7 is the method of embodiment 6, wherein the reconstruction of the input data from the reduce-memory representation of the input data further comprising reconstructing the input data based on the data vector, column index vector, and row index vector input using a Compressed Sparse Row (CSR) reconstruction algorithm when the column index vector stores column indices in the *M x N* matrix for non-zero values and the row index vector stores indices corresponding to the value mapping vector that indicate a start of a row's non-zero value.
Embodiment 8 is the method of embodiment 6, wherein the reconstruction of the input data from the reduce-memory representation of the input data further comprising reconstructing the input data based on the data vector, column index vector, and row index vector input using a Compressed Sparse Column (CSC) reconstruction algorithm when the row index vector stores row indices in the *M x N* matrix for non-zero values and column index vector stores indices corresponding to the value mapping vector that indicate a start of a column's non-zero value.
Embodiment 9 is the method of any one of embodiments 2 to 8, wherein the unique values data is a unique value mapping of each respective unique value to a respective second element value in the value mapping vector.
Embodiment 10 is the computer implemented method of embodiment 9, wherein generating the column index vector and the row index vector comprises: generating a column index vector that includes *K* third elements that respectively correspond to the *K* second elements of the value mapping vector, and each third element value specifies a column value of a column in which a unique value in the unique value mapping mapped to the corresponding second elements of the value mapping vector is located in the *M x N* matrix; and generating, based on the input data, the row index vector of *M +* 1 fourth elements, wherein each of the first *M* fourth elements in the row index vector is an index value of a second element in the value mapping vector mapped to a value in the unique value vector that is a first non-zero value in a corresponding row of the *M x N* matrix.
Embodiment 11 is a system comprising: one or more processors; a non-transitory computer readable memory storing instructions executable by the one or more processes and that upon such execution cause the one or more processors to perform operations comprising: receiving, at computing device, input data defining an *M x N* matrix of *M* rows and *N* columns, and having *M x N* elements, wherein the input data includes *K* non-zero values in the *M x N* elements, and the number of unique values in the *K* non-zero values is J; generating, based on the input data, a unique values data that includes *J* first elements, wherein each first element includes a respective unique value for each unique value in the input data, and each unique value is included in the unique values data only once; generating, based on the unique values data and the input data, a value mapping vector that includes *K* second elements and *J* second element values, each second element value corresponding to a value in the unique values; and storing, in a computer device memory, the unique values data, the value mapping vector, a column index vector, and a row index vector as a reduced-memory representation of the input data, wherein the column index vector and the row index vector respectively indicate, at each element, one of i) column indices in the *M x N* matrix for non-zero values and indices corresponding to the value mapping vector that indicate a start of a row's non-zero value, or ii) row indices in the *M x N* matrix for non-zero values and indices corresponding to the value mapping vector that indicate a start of a column's non-zero value.
Embodiment 12 is the system of embodiment 11, wherein generating the value mapping vector comprises allocating log2(*J*) bits for each second element value.
Embodiment 13 is the system of embodiment 12, wherein: the unique values data is a unique values vector, and each first element is a respective unique value; and each second element value in the value mapping vector is a respective index of the unique values vector.
Embodiment 14 is the system of embodiment 13, further comprising generating the column index vector and the row index vector, comprising: generating the column index vector that includes *K* third elements that respectively correspond to the *K* second elements of the value mapping vector, and each third element value specifies a column value of a column in which a unique value in the unique value vector at the corresponding index value of the value mapping vector is located in the *M x N* matrix; and generating, based on the input data, the row index vector of *M +* 1 fourth elements, wherein each of the first *M* fourth elements in the row index vector is an index value of a second element in the value mapping vector that corresponds to a value in the unique value vector that is a first non-zero value in a corresponding row of the *M x N* matrix.
Embodiment 15 is the system of embodiment 13 or 14, wherein each unique value of the input data is a quantized weight or activation of an element in a neural network layer.
Embodiment 16 is the system of any one of embodiments 12 to 15, further comprising reconstruction of the input data from the reduced-memory representation of the input data, comprising: generating, from the unique values vector and the value mapping vector, a data vector, wherein the data vector includes *K* fifth elements that are the *K* non-zero values in the *M x N* elements.
Embodiment 17 is the system of embodiment 16, wherein the reconstruction of the input data from the reduce-memory representation of the input data further comprising reconstructing the input data based on the data vector, column index vector, and row index vector input using a Compressed Sparse Row (CSR) reconstruction algorithm when the column index vector stores column indices in the *M x N* matrix for non-zero values and the row index vector stores indices corresponding to the value mapping vector that indicate a start of a row's non-zero value.
Embodiment 18 is the system of embodiment 16, wherein the reconstruction of the input data from the reduce-memory representation of the input data further comprising reconstructing the input data based on the data vector, column index vector, and row index vector input using a Compressed Sparse Column (CSC) reconstruction algorithm when the row index vector stores row indices in the *M x N* matrix for non-zero values and column index vector stores indices corresponding to the value mapping vector that indicate a start of a column's non-zero value.
Embodiment 19 is system of any one of embodiments 12 to 18, wherein the unique values data is a unique value mapping of each respective unique value to a respective second element value in the value mapping vector.
Embodiment 20 is a non-transitory computer memory storing instructions executable by the one or more processes and that upon such execution cause the one or more processors to perform operations comprising: receiving, at computing device, input data defining an *M x N* matrix of *M* rows and *N* columns, and having *M x N* elements, wherein the input data includes *K* non-zero values in the *M x N* elements, and the number of unique values in the *K* non-zero values is J; generating, based on the input data, a unique values data that includes *J* first elements, wherein each first element includes a respective unique value for each unique value in the input data, and each unique value is included in the unique values data only once; generating, based on the unique values data and the input data, a value mapping vector that includes *K* second elements and *J* second element values, each second element value corresponding to a value in the unique values; and storing, in a computer device memory, the unique values data, the value mapping vector, a column index vector, and a row index vector as a reduced-memory representation of the input data, wherein the column index vector and the row index vector respectively indicate, at each element, one of i) column indices in the *M x N* matrix for non-zero values and indices corresponding to the value mapping vector that indicate a start of a row's non-zero value, or ii) row indices in the *M x N* matrix for non-zero values and indices corresponding to the value mapping vector that indicate a start of a column's non-zero value.

While this specification contains many specific implementation details, these should not be construed as limitations on the scope of any invention or on the scope of what may be claimed, but rather as descriptions of features that may be specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially be claimed as such, one or more features from a claimed combination can in some cases be excised from the combination, and the claimed combination may be directed to a subcombination or variation of a subcombination.

Similarly, while operations are depicted in the drawings and recited in the claims in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system modules and components in the embodiments described above should not be understood as requiring such separation in all embodiments, and it should be understood that the described program components and systems can generally be integrated together in a single software product or packaged into multiple software products.

Particular embodiments of the subject matter have been described. Other embodiments are within the scope of the following claims. For example, the actions recited in the claims can be performed in a different order and still achieve desirable results. As one example, the processes depicted in the accompanying figures do not necessarily require the particular order shown, or sequential order, to achieve desirable results. In some cases, multitasking and parallel processing may be advantageous.

## Claims

1. A computer-implemented method performed using computing device to reduce storage in a data representation, the method comprising:
receiving, at computing device, input data defining an *M x N* matrix of *M* rows and *N* columns, and having *M x N* elements, wherein the input data includes *K* non-zero values in the *M x N* elements, and the number of unique values in the *K* non-zero values is J;
generating, based on the input data, a unique values data that includes *J* first elements, wherein each first element includes a respective unique value for each unique value in the input data, and each unique value is included in the unique values data only once;
generating, based on the unique values data and the input data, a value mapping vector that includes *K* second elements and *J* second element values, each second element value corresponding to a value in the unique values; and
storing, in a computer device memory, the unique values data, the value mapping vector, a column index vector, and a row index vector as a reduced-memory representation of the input data, wherein the column index vector and the row index vector respectively indicate, at each element, one of i) column indices in the *M x N* matrix for non-zero values and indices corresponding to the value mapping vector that indicate a start of a row's non-zero value, or ii) row indices in the *M x N* matrix for non-zero values and indices corresponding to the value mapping vector that indicate a start of a column's non-zero value.

2. The method of claim 1, wherein generating the value mapping vector comprises allocating log2(*J*) bits for each second element value.

3. The method of claim 2, wherein:
the unique values data is a unique values vector, and each first element is a respective unique value; and
each second element value in the value mapping vector is a respective index of the unique values vector.

4. The computer implemented method of claim 3, further comprising generating the column index vector and the row index vector, comprising:
generating the column index vector that includes *K* third elements that respectively correspond to the *K* second elements of the value mapping vector, and each third element value specifies a column value of a column in which a unique value in the unique value vector at the corresponding index value of the value mapping vector is located in the *M x N* matrix; and
generating, based on the input data, the row index vector of *M* + 1 fourth elements, wherein each of the first *M* fourth elements in the row index vector is an index value of a second element in the value mapping vector that corresponds to a value in the unique value vector that is a first non-zero value in a corresponding row of the *M x N* matrix.

5. The method of claim 3 or 4, wherein each unique value of the input data is a quantized weight or activation of an element in a neural network layer.

6. The method of any one of claims 2 to 5, further comprising reconstruction of the input data from the reduced-memory representation of the input data, comprising:
generating, from the unique values vector and the value mapping vector, a data vector, wherein the data vector includes *K* fifth elements that are the *K* non-zero values in the *M x N* elements.

7. The method of claim 6, wherein the reconstruction of the input data from the reduce-memory representation of the input data further comprising reconstructing the input data based on the data vector, column index vector, and row index vector input using a Compressed Sparse Row (CSR) reconstruction algorithm when the column index vector stores column indices in the *M x N* matrix for non-zero values and the row index vector stores indices corresponding to the value mapping vector that indicate a start of a row's non-zero value.

8. The method of claim 6, wherein the reconstruction of the input data from the reduce-memory representation of the input data further comprising reconstructing the input data based on the data vector, column index vector, and row index vector input using a Compressed Sparse Column (CSC) reconstruction algorithm when the row index vector stores row indices in the *M x N* matrix for non-zero values and column index vector stores indices corresponding to the value mapping vector that indicate a start of a column's non-zero value.

9. The method of any one of claims 2 to 8, wherein the unique values data is a unique value mapping of each respective unique value to a respective second element value in the value mapping vector.

10. The computer implemented method of claim 9, wherein generating the column index vector and the row index vector comprises:
generating a column index vector that includes *K* third elements that respectively correspond to the *K* second elements of the value mapping vector, and each third element value specifies a column value of a column in which a unique value in the unique value mapping mapped to the corresponding second elements of the value mapping vector is located in the *M x N* matrix; and
generating, based on the input data, the row index vector of *M +* 1 fourth elements, wherein each of the first *M* fourth elements in the row index vector is an index value of a second element in the value mapping vector mapped to a value in the unique value vector that is a first non-zero value in a corresponding row of the *M x N* matrix.

11. A system comprising:
one or more processors;
a non-transitory computer readable memory storing instructions executable by the one or more processes and that upon such execution cause the one or more processors to perform operations comprising:
receiving, at computing device, input data defining an *M x N* matrix of *M* rows and *N* columns, and having *M x N* elements, wherein the input data includes *K* non-zero values in the *M x N* elements, and the number of unique values in the *K* non-zero values is J;
generating, based on the input data, a unique values data that includes *J* first elements, wherein each first element includes a respective unique value for each unique value in the input data, and each unique value is included in the unique values data only once;
generating, based on the unique values data and the input data, a value mapping vector that includes *K* second elements and *J* second element values, each second element value corresponding to a value in the unique values; and
storing, in a computer device memory, the unique values data, the value mapping vector, a column index vector, and a row index vector as a reduced-memory representation of the input data, wherein the column index vector and the row index vector respectively indicate, at each element, one of i) column indices in the *M x N* matrix for non-zero values and indices corresponding to the value mapping vector that indicate a start of a row's non-zero value, or ii) row indices in the *M x N* matrix for non-zero values and indices corresponding to the value mapping vector that indicate a start of a column's non-zero value.

12. The system of claim 11, wherein generating the value mapping vector comprises allocating log2(*J*) bits for each second element value.

13. The system of claim 12, wherein:
the unique values data is a unique values vector, and each first element is a respective unique value; and
each second element value in the value mapping vector is a respective index of the unique values vector.

14. The system of claim 13, further comprising generating the column index vector and the row index vector, comprising:
generating the column index vector that includes *K* third elements that respectively correspond to the *K* second elements of the value mapping vector, and each third element value specifies a column value of a column in which a unique value in the unique value vector at the corresponding index value of the value mapping vector is located in the *M x N* matrix; and
generating, based on the input data, the row index vector of *M +* 1 fourth elements, wherein each of the first *M* fourth elements in the row index vector is an index value of a second element in the value mapping vector that corresponds to a value in the unique value vector that is a first non-zero value in a corresponding row of the *M x N* matrix.

15. A non-transitory computer memory storing instructions executable by the one or more processes and that upon such execution cause the one or more processors to perform operations comprising:
receiving, at computing device, input data defining an *M x N* matrix of *M* rows and *N* columns, and having *M x N* elements, wherein the input data includes *K* non-zero values in the *M x N* elements, and the number of unique values in the *K* non-zero values is J;
generating, based on the input data, a unique values data that includes *J* first elements, wherein each first element includes a respective unique value for each unique value in the input data, and each unique value is included in the unique values data only once;
generating, based on the unique values data and the input data, a value mapping vector that includes *K* second elements and *J* second element values, each second element value corresponding to a value in the unique values; and
storing, in a computer device memory, the unique values data, the value mapping vector, a column index vector, and a row index vector as a reduced-memory representation of the input data, wherein the column index vector and the row index vector respectively indicate, at each element, one of i) column indices in the *M x N* matrix for non-zero values and indices corresponding to the value mapping vector that indicate a start of a row's non-zero value, or ii) row indices in the *M x N* matrix for non-zero values and indices corresponding to the value mapping vector that indicate a start of a column's non-zero value.
